# EUROPEAN PATENT APPLICATION

(11) **EP 4 068 331 A1**
(43) Date of publication of application: **05.10.2022**
(21) Application number: 21166211.9
(22) Date of filing: 31.03.2021
(51) Int. Cl.: H01J 37/02

(54) **ELECTRON-OPTICAL SYSTEM AND METHOD OF OPERATING AN ELECTRON-OPTICAL SYSTEM**

(71) Applicant: ASML Netherlands B.V., 5500 AH Veldhoven (NL)
(72) Inventor: STEENBRINK, Stijn, Wilem, Herman, Karel, 5500 AH Veldhoven (NL)
(74) Representative: ASML Netherlands B.V.

(57) **Abstract**

Electron-optical systems comprising a particle trap and methods of operating electron-optical systems using a particle trap are disclosed. In one arrangement, a stage supports a sample. An objective lens arrangement projects electrons towards the sample along an electron-beam path. A particle trap comprises an electrode assembly radially outside of the objective lens arrangement and facing the sample. The electrode assembly draws a particle away from a surface of the sample and/or stage as the sample moves relative to the electron-beam path.

## Description

### FIELD

The embodiments provided herein generally relate to electron-optical systems comprising a particle trap and methods of operating electron-optical systems using a particle trap.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incidental particles or other processing step such as etching, deposition, or chemical mechanical polishing. Monitoring the extent of the undesired pattern defects is therefore an important process in the manufacture of IC chips. More generally, the inspection and/or measurement of a surface of a sample such as a substrate, or other object/material, is an important process during and/or after its manufacture.

Pattern inspection tools with a charged particle beam have been used to inspect objects, often referred to as samples, for example to detect pattern defects. These tools typically use electron microscopy techniques, such as a scanning electron microscope (SEM). In a SEM, a primary electron beam of electrons at a relatively high energy is targeted with a final deceleration step in order to land on a target at a relatively low landing energy. The beam of electrons is focused as a probing spot on the target. The interactions between the material structure at the probing spot and the landing electrons from the beam of electrons cause electrons to be emitted from the surface, sometimes referred to as 'signal electrons', such as secondary electrons, backscattered electrons or Auger electrons. The generated secondary electrons may be emitted from the material structure of the target.

By scanning the primary electron beam as the probing spot over the target surface, signal electrons can be emitted across the surface of the target. By collecting these emitted signal electrons from the target surface, a pattern inspection tool may obtain an image-like signal representing characteristics of the material structure of the surface of the target. In such inspection the collected secondary electrons are detected by a detector within the tool. The detector generates a signal in response to the incident particles. As an area of the sample is inspected, the signals comprise data which is processed to generate the inspection image corresponding to the inspected area of the sample. The image may comprise pixels. Each pixel may correspond to a portion of the inspected area. Typically, the electron beam inspection tool has a single beam and may be referred to as a Single Beam SEM. There have been attempts to introduce a multi-electron-beam inspection tool (or a 'multi-beam tool') which may be referred to as Multi Beam SEM (MBSEM). Electron beam inspection tools may comprise an electron-optical column to guide and control the electron beam or electron beams in the inspection process.

Another application for electron-optical columns is in lithography. In applications of this type, a charged particle beam may be made to react with a resist layer on the surface of a substrate. A desired pattern in the resist can be created by controlling the locations on the resist layer that the charged particle beam is directed towards.

An electron-optical column may be an apparatus for generating, illuminating, projecting and/or detecting one or more beams of charged particles. The path of the beam of charged particles is controlled by electromagnetic fields (i.e. electrostatic fields and magnetic fields). High electric fields can present a risk of electrostatic breakdown. Electrostatic breakdown can introduce errors during operation of, or damage to, the electron-optical column. Electrostatic breakdown can be triggered by field concentration caused by particles such as contaminant debris entering high field regions of electron-optical columns, for example after being drawn up from the surface of a sample, such as a substrate.

It is an object of the present disclosure to reduce the risk of electrostatic breakdown in electron-optical columns.

### SUMMARY

According to an aspect, there is provided an electron-optical system, comprising: a stage configured to support a sample; an objective lens arrangement of an electron-optical column configured to project electrons towards the sample along an electron-beam path, the stage configured to move the sample relative to the electron-beam path; and a particle trap comprising: an electrode assembly radially outside of the objective lens arrangement and configured to face towards the sample, the electrode assembly being configured to draw a particle away from a surface of the sample and/or stage as the sample moves relative to the electron-beam path.

According to an aspect, there is provided a method of operating an electron-optical system, comprising: projecting electrons towards the sample along an electron-beam path using an objective lens arrangement; moving the sample on a stage relative to the electron-beam path; and drawing a particle away from a surface of the sample and/or stage as the sample moves.

According to an aspect of the invention, there is provided a particle trap for an electron-optical system, the electron-optical system comprising an objective lens of an electron-optical column configured to project electrons towards a sample along an electron-beam path, the particle trap comprising: an electrode assembly configured to be mounted radially outside of the objective lens arrangement and to face towards the sample, the electrode assembly being configured to draw a particle away from a surface of the sample, and/or a stage on which the sample is supported, as the sample moves relative to the electron-beam path.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary charged particle beam inspection apparatus.
Figure 2 is a schematic diagram illustrating an exemplary multi-beam electron-optical column that is part of the exemplary inspection apparatus of Figure 1.
Figure 3 is a schematic diagram of an exemplary electron-optical column having a collimator element array and a scan-deflector array.
Figure 4 is a schematic diagram of an exemplary electron-optical column array comprising the electron-optical columns of Figure 3.
Figure 5 is a schematic diagram of an alternative exemplary electron-optical system that may be part of the exemplary inspection apparatus of Figure 1.
Figure 6 is a schematic diagram of an exemplary single beam electron-optical column that may be part of the exemplary inspection apparatus of Figure 1.
Figures 7-9 are schematic side sectional views of an objective lens arrangement at different stages of a contaminant particle being forced by electrostatic effects to move upwards from a sample surface into the objective lens arrangement to cause a particle-induced electrical breakdown event in the objective lens arrangement.
Figure 10 is a schematic side sectional view of an objective lens arrangement radially surrounded by a particle trap.
Figures 11-13 are schematic side sectional views of a particle trap at different stages of pulling a contaminant particle from a sample surface into the particle trap.
Figure 14 is a schematic side sectional view of a region around an opening into a particle trap, showing equipotential lines of an electric field.
Figures 15-18 are schematic views looking upwards along a beam path of different example configurations of openings in a sample-facing electrode of a particle trap.
Figure 19 is a schematic side sectional view of an objective lens arrangement radially surrounded by a particle trap in a case where the objective lens arrangement comprises a magnetic lens (additional electrodes of the lens unit within the magnetic objective lens not depicted).

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution, enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by inspection tools (such as a Scanning Electron Microscope ('SEM')) is desirable for maintaining high yield and low cost for IC chips.

A SEM comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as secondary electrons and/or backscattered electrons. The detection apparatus captures the secondary electrons and/or backscattered electrons from the target as the target is scanned so that the SEM may create an image of the scanned area of the target. A design of electron-optical system embodying these SEM features may have a single beam. For higher throughput such as for inspection, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam inspection apparatus may therefore inspect a target much quicker, e.g. by moving the target at a higher speed, than a single-beam inspection apparatus.

In a multi-beam inspection apparatus, the paths of some of the primary electron beams are displaced away from the central axis, i.e. a mid-point of the primary electron-optical axis (also referred to herein as the charged particle axis), of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations that cause the resulting image to be blurry and out-of-focus. An example is spherical aberrations which bring the focus of each sub-beam path into a different focal plane. In particular, for sub-beam paths that are not on the central axis, the change in focal plane in the sub-beams increases with increasing radial displacement from the central axis. Such aberrations and defocus effects may remain associated with the secondary electrons from the target when they are detected; for example the shape and size of the spot formed by the sub-beam on the target will be affected. Such aberrations therefore degrade the quality of resulting images that are created during inspection.

An implementation of a known multi-beam inspection apparatus is described below.

The drawings are schematic. Relative dimensions of components in drawings are exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally considered as references to charged particles, and items referred to with reference to charged particles, with the charged particles not necessarily being electrons.

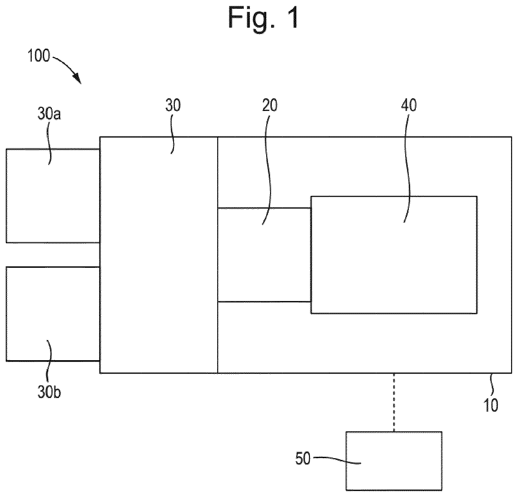

Reference is now made to Figure 1, which is a schematic diagram illustrating an exemplary charged particle beam inspection apparatus 100. The inspection apparatus 100 of Fig. 1 includes a vacuum chamber 10, a load lock chamber 20, an electron-optical column 40 (also known as an electron beam column), an equipment front end module (EFEM) 30 and a controller 50. The electron optical column 40 may be within the vacuum chamber 10.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be inspected (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the electron-optical column 40 by which it may be inspected. An electron-optical column 40 may comprise either a single beam or a multi-beam electron-optical apparatus.

The controller 50 is electronically connected to the electron-optical column 40. The controller 50 may be a processor (such as a computer) configured to control the charged particle beam inspection apparatus 100. The controller 50 may also include processing circuitry configured to execute various signal and image processing functions. While the controller 50 is shown in Figure 1 as being outside of the structure that includes the main chamber 10, the load lock chamber 20, and the EFEM 30, it is will be appreciated that the controller 50 may be part of the structure. The controller 50 may be located in one of the component elements of the charged particle beam inspection apparatus or it may be distributed over at least two of the component elements. While the present disclosure provides examples of main chambers 10 housing an electron beam inspection tool, it should be noted that aspects of the disclosure in their broadest sense are not limited to a chamber housing an electron beam column. Rather, it is appreciated that the foregoing principles may also be applied to other tools and other arrangements of apparatus that operate under the second pressure.

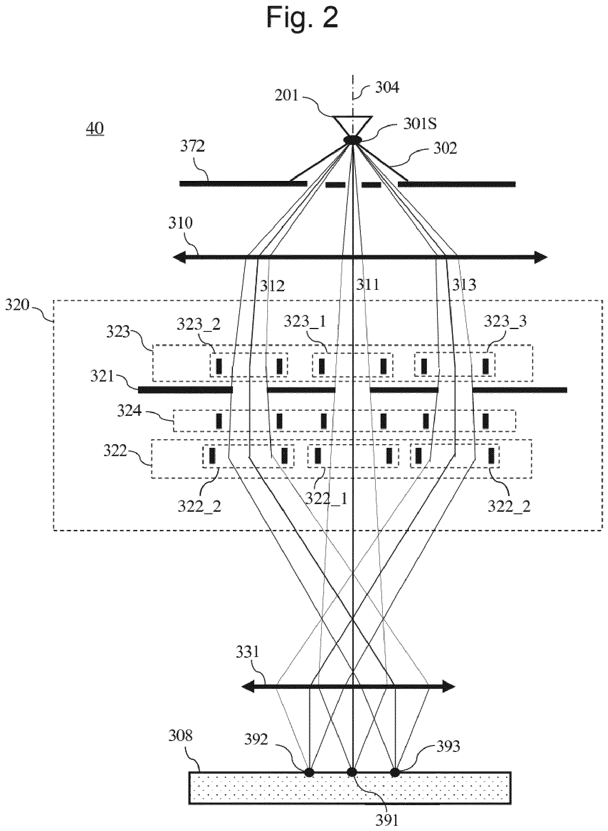

Reference is now made to Figure 2, which is a schematic diagram of an exemplary multi-beam electron-optical column 40 that may be provided as part of the inspection apparatus 100 of Figure 1. In an alternative embodiment the inspection apparatus 100 is a single-beam inspection apparatus. The electron-optical column 40 comprises an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In an embodiment the condenser lens 310 is magnetic. The target 308 may be supported by a support on a stage. The stage may be motorized. The stage moves so that the target 308 is scanned by the incidental electrons. The electron source 201, the beam former array 372, and the condenser lens 310 may be the components of an illumination apparatus comprised by the electron-optical column 40. The source converter 320 (also known as a source conversion unit), described in more detail below, and the objective lens 331 may be the components of a projection apparatus comprised by the electron-optical column 40.

The electron source 201, the beam former array 372, the condenser lens 310, the source converter 320, and the objective lens 331 are aligned with a primary electron-optical axis 304 of the electron-optical column 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to an electron-optical column 40 with any number of sub-beams such as one, two or more than three. The beam former array 372, in operation, is configured to block off peripheral electrons to reduce the Coulomb effect. The Coulomb effect may enlarge the size of each of the probe spots 391, 392, 393 and therefore deteriorate inspection resolution. The beam former array 372 reduces aberrations resulting from Coulomb interactions between electrons projected in the beam. The beam former array 372 may include multiple openings for generating primary sub-beams even before the source converter 320.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in Figure 2, in an embodiment the electron-optical column 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system up-beam of the main column. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in Figure 2, in an embodiment the electron-optical column 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The electron-optical column 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The electron-optical column 40 may also include an aberration compensator array 324 configured to compensate aberrations that may be present in each of the sub-beams. In an embodiment the aberration compensator array 324 comprises a lens configured to operate on a respective beamlet. The lens may take the form of an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The source converter 320 may further comprise a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams onto the beam-limiting aperture array 321. In an embodiment, the pre-bending micro-deflector array 323 may be configured to bend the sub-beam path of sub-beams towards the orthogonal of the plane of the beam-limiting aperture array 321. In an alternative embodiment the condenser lens 310 may adjust the path direction of the sub-beams onto the beam-limiting aperture array 321. The condenser lens 310 may, for example, focus (collimate) the three sub-beams 311, 312, and 313 to become substantially parallel beams along primary electron-optical axis 304, so that the three sub-beams 311, 312, and 313 are incident substantially perpendicularly onto source converter 320, which may correspond to the beam-limiting aperture array 321. In such alternative embodiment the pre-bending deflector array 323 may not be necessary.

The image-forming element array 322, the aberration compensator array 324, and the pre-bending deflector array 323 may comprise multiple layers of sub-beam manipulating devices, some of which may be in the form or arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

In the current example of the electron-optical column 40, the beamlets are respectively deflected by the deflectors 322_1, 322_2, and 322_3 of the image-forming element array 322 towards the electron-optical axis 304. It should be understood that the beamlet path may already correspond to the electron-optical axis 304 prior to reaching deflector 322_1, 322_2, and 322_3.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of the three probe spots 391 to 393. In an arrangement the objective lens 331 is magnetic. Although three beamlets are mentioned, this is by way of example only. There may be any number of beamlets.

A manipulator is configured to manipulate one or more beams of charged particles. The term manipulator encompasses a deflector, a lens and an aperture. The pre-bending deflector array 323, the aberration compensator array 324 and the image-forming element array 322 may individually or in combination with each other, be referred to as a manipulator array, because they manipulate one or more sub-beams or beamlets of charged particles. The lens and the deflectors 322_1, 322_2, and 322_3 may be referred to as manipulators because they manipulate one or more sub-beams or beamlets of charged particles.

In an embodiment a beam separator (not shown) is provided. The beam separator may be down-beam of the source converter 320. The beam separator may be, for example, a Wien filter comprising an electrostatic dipole field and a magnetic dipole field. The beam separator may be positioned between adjacent sections of shielding (described in more detail below) in the direction of the beam path. The inner surface of the shielding may be radially inward of the beam separator. Alternatively, the beam separator may be within the shielding. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons generally move in an opposite direction compared to the primary electrons, the magnetic force exerted on the secondary electrons and backscattered electrons will no longer cancel the electrostatic force and as a result the secondary electrons and backscattered electrons moving through the beam separator will be deflected away from the electron-optical axis 304.

In an embodiment a secondary column (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary column. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons.

In an embodiment the inspection apparatus 100 comprises a single source.

Any element or collection of elements may be replaceable or field replaceable within the electron-optical column. The one or more electron-optical components in the column, especially those that operate on sub-beams or generate sub-beams, such as aperture arrays and manipulator arrays may comprise one or more microelectromechanical systems (MEMS). The pre-bending deflector array 323 may be a MEMS. MEMS are miniaturized mechanical and electromechanical elements that are made using microfabrication techniques. In an embodiment the electron-optical column 40 comprises apertures, lenses and deflectors formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

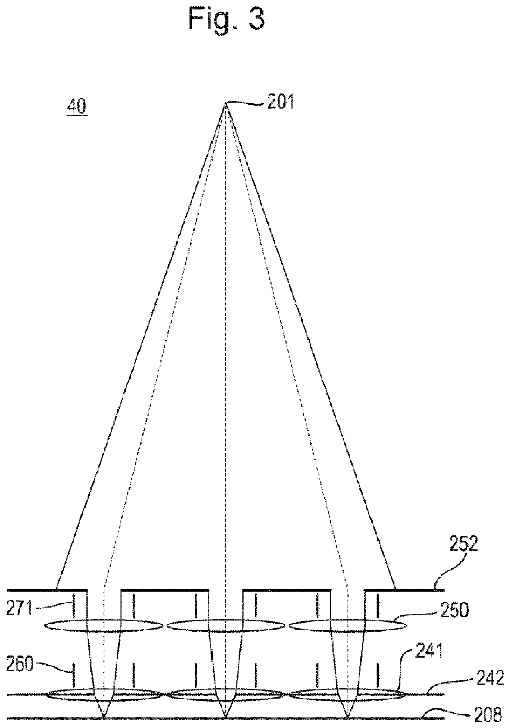

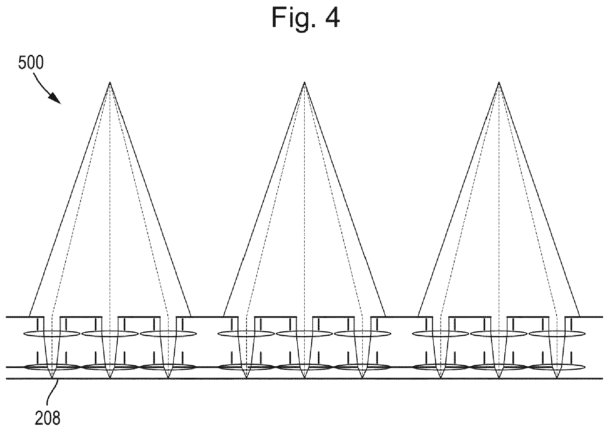

In an embodiment the electron-optical column 40 may comprise alternative and/or additional components on the charged particle path, such as lenses and other components some of which have been described earlier with reference to Figures 1 and 2. Examples of such arrangements are shown in Figures 3 and 4 which are described in further detail later. In particular, embodiments include an electron-optical column 40 that divides a charged particle beam from a source into a plurality of sub-beams. A plurality of respective objective lenses may project the sub-beams onto a sample. In some embodiments, a plurality of condenser lenses is provided up-beam from the objective lenses. The condenser lenses are separated from a module containing the objective lenses (such as an objective lens array assembly 250 as discussed below). In a case where the potential applied on a bottom surface of the condenser lenses is different than the potential applied on the top surface of the module containing the objective lenses an isolating spacer is used to space apart the condenser lenses and the module containing the objective lenses. In a case where the potential is equal then a conductive element can be used to space apart the condenser lenses and the module containing the objective lenses. The condenser lenses focus each of the sub-beams to an intermediate focus up-beam of the objective lenses. In some embodiments, collimators are provided up-beam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. The condenser lenses and correctors may be part of the same structure. For example they may be connected to each other, for example with an electrically isolating element. A detector is provided to detect charged particles emitted by the sample. The detector may be integrated into the objective lens. The detector and objective lens may be part of the same structure. The detector may be connected to the lens by an isolating element or directly to an electrode of the objective lens. The detector may be on the bottom surface of the objective lens so as to face a sample in use. The detector may comprise an array which may correspond to the array of the beamlets of the multi-beam arrangement. The detectors in the detector array may generate detection signals that may be associated with the pixels of a generated image. The condenser lenses, objective lenses and/or detector may be formed as MEMS or CMOS devices.

Figure 3 is a schematic diagram of another design of exemplary electron-optical column 40. The electron-optical column 40 may comprise a source 201. The electron-optical column 40 may comprise an upper beam limiter 252, a collimator element array 271, a control lens array 250, a scan deflector array 260, an objective lens array 241, a beam shaping limiter 242 and a detector array; one or more of these elements may be connected to one more adjacent elements with an isolating element such as a ceramic spacer. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current.

The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided down-beam of the upper beam limiter. Each collimator element collimates a respective sub-beam. The collimator element array 271 may be formed using MEMS manufacturing techniques so as to be spatially compact. In some embodiments, exemplified in Figure 3, the collimator element array 271 is the first deflecting or focusing electron-optical array element in the beam path down-beam of the source 201. In another arrangement, the collimator may take the form, wholly or partially, of a macro-collimator. Such a macro-collimator may be up beam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. Each plate electrode array is mechanically connected to, and electrically separated from, an adjacent plate electrode array by an isolating element, such as a spacer which may comprise ceramic or glass. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. A scan-deflector array 260 (e.g. formed using MEMS manufacturing techniques as mentioned above) may be more spatially compact than a macro scan deflector. In another arrangement, a macro scan deflector may be used up beam of the upper beam limiter 252. Its function may be similar or equivalent to the scan-deflector array although it operates on the beam from the source before the beamlets of the multi-beam are generated.

The objective lens array 241 comprising a plurality of objective lenses is provided to direct the sub-beams onto the sample 208. Each objective lens comprises at least two electrodes (e.g. two or three electrodes) connected to respective potential sources. The objective lens array 241 may comprise two or more (e.g. three) plate electrode arrays connected to respective potential sources. Each plate electrode array is mechanically connected to, and electrically separated from, an adjacent plate electrode array by an isolating element, such as a spacer which may comprise ceramic or glass. Each objective lens formed by the plate electrode arrays may be a micro-lens operating on a different sub-beam. Each plate defines a plurality of apertures (which may also be referred to as holes). The position of each aperture in a plate corresponds to the position of a corresponding aperture (or apertures) in the other plate (or plates). The corresponding apertures define the objective lenses and each set of corresponding apertures therefore operates in use on the same sub-beam in the multi-beam. Each objective lens projects a respective sub-beam of the multi-beam onto a sample 208.

The objective lens array may form part of an objective lens array assembly along with any or all of the scan-deflector array 260, control lens array 250 and collimator element array 271. The objective lens array assembly 250 may comprise part or all of an objective lens arrangement. The objective lens array assembly may further comprise the beam shaping limiter 242. The beam shaping limiter 242 defines an array of beam-limiting apertures. The beam shaping limiter 242 may be referred to as a lower beam limiter, lower beam-limiting aperture array or final beam-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is down-beam from at least one electrode (optionally from all electrodes) of the objective lens array 241. The plate of the beam limiter 242 may be connected to an adjacent plate electrode array of the objective lens by an isolating element, such as a spacer which may comprise ceramic or glass.

In an arrangement, the beam shaping limiter 242 is structurally integrated with an electrode of the objective lens array 241. That is, the plate of the beam limiter 242 is connected directly to the adjacent plate electrode array of the objective lens 241. Desirably, the beam shaping limiter 242 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping limiter 242 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

In an embodiment, the electron-optical column 40 is configured to control the objective lens array assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to form a combined focal length to the same surface. Combined operation without an intermediate focus may reduce the risk of aberrations. In other embodiments, the objective lens array assembly may be configured to form an intermediate focus between the control lens array 250 and the objective lens array 241.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise two or three or more electrodes. If there are two electrodes then the demagnification and landing energy are controlled together. If there are three or more electrodes the demagnification and landing energy can be controlled independently. The control lenses may thus be configured to adjust the demagnification and/or beam opening angle and/or the landing energy on the substrate of respective sub-beams (e.g. using the electric power source to apply suitable respective potentials to the electrodes of the control lenses and the objective lenses). This optimization can be achieved without having an excessively negative impact on the number of objective lenses and without excessively deteriorating aberrations of the objective lenses (e.g. without decreasing the strength of the objective lenses). Use of the control lens array enables the objective lens array to operate at its optimal electric field strength. Note that the reference to demagnification and opening angle is intended to refer to variation of the same parameter. In an ideal arrangement the product of a range of demagnification and the corresponding opening angles is constant. However, the opening angle may be influenced by the use of an aperture.

In an embodiment, the landing energy can be controlled to a desired value in a predetermined range, e.g. from 1000 eV to 5000 eV. Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can function to change the demagnification in view of changes in landing energy. Desirably, each control lens comprises three electrodes so as to provide two independent control variables. For example, one of the electrodes can be used to control magnification while a different electrode can be used to independently control landing energy. Alternatively each control lens may have only two electrodes. When there are only two electrodes, one of the electrodes may need to control both magnification and landing energy.

The detector array (not shown) is provided to detect charged particles emitted from the sample 208. The detected charged particles may include any of the charged particles detected by an SEM, including secondary and/or backscattered electrons emitted from the sample 208. The detector may be an array providing the surface of the column facing the sample 208, e.g. the bottom surface of the column. Alternatively, the detector array may be up-beam of the bottom surface for example in or up-beam of the objective lens array or the control lens array. The elements of the detector array may correspond to the beamlets of the multi-beam arrangement. The signal generated by detection of an electron by an element of the array may be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in Figure 4, an electron-optical column array 500 is provided. The array 500 may comprise a plurality of any of the electron-optical columns described herein. Each of the electron-optical columns focuses respective multi-beams simultaneously onto different regions of the same sample. Each electron-optical column may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical columns in the array 500 may be arranged adjacent to each other so as to project the respective multi-beams onto adjacent regions of the sample 208.

Any number of electron-optical columns may be used in the array 500. Preferably, the number of electron-optical columns is in the range of from 2 (preferably 9) to 200. In an embodiment, the electron-optical columns are arranged in a rectangular array or in a hexagonal array. In other embodiments, the electron-optical columns are provided in an irregular array or in a regular array having a geometry other than rectangular or hexagonal. Each electron-optical column in the array 500 may be configured in any of the ways described herein when referring to a single electron-optical column, for example as described above, especially with respect to the embodiment shown and described in reference to Figure 3. Details of such an arrangement is described in EPA 20184161.6 filed 6 July 2020 which, with respect to how the objective lens is incorporated and adapted for use in the multi-column arrangement is hereby incorporated by reference.

In the example of Figure 4 the array 500 comprises a plurality of electron-optical columns of the type described above with reference to Figure 3. Each of the electron-optical columns in this example thus comprise both a scan-deflector array 260 and a collimator element array 271. As mentioned above, the scan-deflector array 260 and collimator element array 271 are particularly well suited to incorporation into an electron-optical column array 500 because of their spatial compactness, which facilitates positioning of the electron-optical columns close to each other. This arrangement of electron optical column may be preferred over other arrangements that use a magnetic lens as collimator. Magnetic lenses may be challenging to incorporate into an electron-optical column intended for use in a multi-column arrangement.

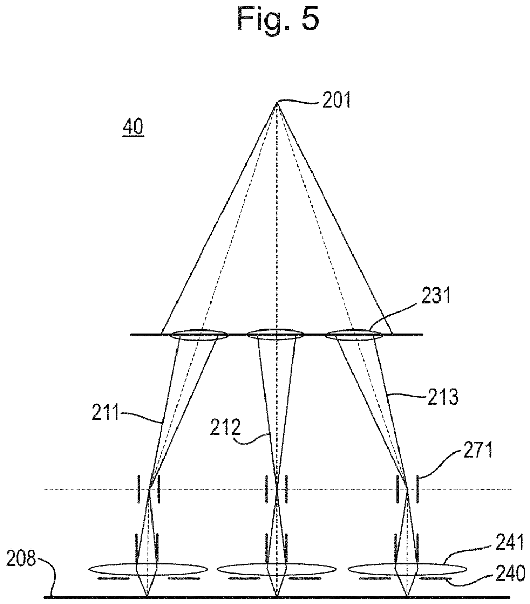

An alternative design of multi-beam electron optical column may have the same features as described with respect to Figure 3 except as described below and illustrated in Figure 5. The alternative design of multi-beam electron optical column may comprise a condenser lens array 231 upbeam of the objective lens array array 241, as disclosed in EP application 20158804.3 filed on 21 February 2020 which is hereby incorporated by reference so far as the description of the multi-beam column with a collimator and its components. Such a design does not require the beam shaping limiter array 242 or the upper beam limiter array 252 because a beam limiting aperture array associated with condenser lens array 231 may shape the beamlets 211, 212, 213 of the multi-beam from the beam of the source 201. The beam limiting aperture array of the condenser lens may also function as an electrode in the lens array. The condenser lens array 231 may have two or more plate electrodes each with an array of apertures that are aligned. Each plate electrode array is mechanically connected to, and electrically isolated from, an adjacent plate electrode array by an isolating element, such as a spacer which may comprise ceramic or glass. The condenser lens array may be connected and/or spaced apart from an adjacent electron-optical element, preferably an electrostatic electron-optical element, by an isolating element such as a spacer as described elsewhere herein.

The paths of the beamlets 211, 212, 213 diverge away from the condenser lens array 231. The condenser lens array 231 focuses the generated beamlets to an intermediate focus between the condenser lens array 231 and the objective lens array assembly 241 (i.e. towards the control lens array, where present, and the objective lens array). The collimator array 271 may be at the intermediate foci instead of associated with the objective lens array 241.

The collimator may reduce the divergence of the diverging beamlet paths. The collimator may collimate the diverging beamlet paths so that they are substantially parallel towards the objective lens array assembly. Corrector arrays may be present in the multi-beam path, for example associated with the condenser lens array, the intermediate foci and the objective lens array assembly. The detector 240 may be integrated into the objective lens array 241. The detector 240 may be on the bottom surface of the objective lens array 241 so as to face a sample in use.

An electron-optical column array may have multiple multi-beam columns of this design as described with reference to the multi-beam column of Figure 3 as shown in Figure 4. Such an arrangement is shown and described in EP Application 20158732.6 filed on 21 February 2020 which is hereby incorporated by reference with respect to the multi-column arrangement of a multi-beam tool featuring the design of multi-beam column disclosed with a collimator at an intermediate focus.

A further alternative design of multi-beam tool comprises multiple single beam columns. The single beams generated for the purposes of the invention herein described may be similar or equivalent to a multi-beam generated by a single column. Such a multi-column tool may have one hundred columns each generating a single beam or beamlet. In this further alternative design the single beam columns may have a common vacuum system, each column have a separate vacuum system or groups of columns are assigned different vacuum systems. Each column may have an associated detector.

The electron-optical column 40 may be a component of an assessment tool; such as an inspection tool or a metro-inspection tool, or part of an e-beam lithography tool. The multi-beam charged particle apparatus may be used in a number of different applications that include electron microscopy in general, not just SEM, and lithography.

The electron-optical axis 304 describes the path of charged particles through and output from the source 201. The sub-beams and beamlets of a multi-beam may all be substantially parallel to the electron-optical axis 304 at least through the manipulators or electron-optical arrays, unless explicitly mentioned. The electron-optical axis 304 may be the same as, or different from, a mechanical axis of the electron-optical column 40.

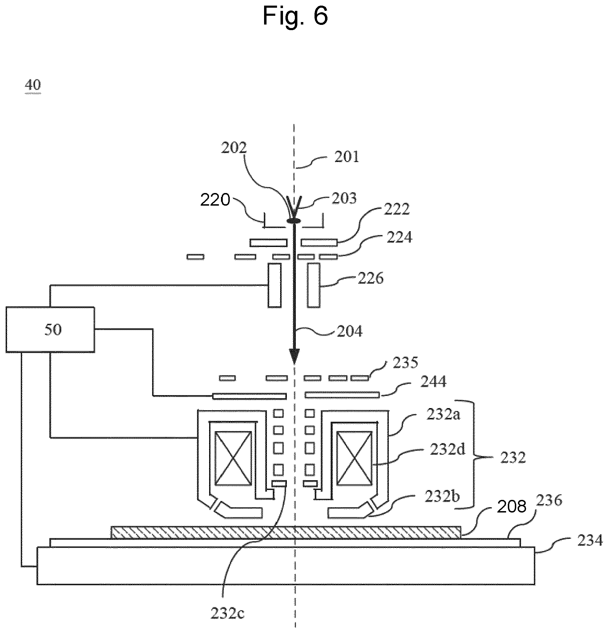

Reference is now made to Figure 6, which is a schematic diagram of an exemplary single beam electron-optical column 40 (also referred to as apparatus 40) of the inspection apparatus 100 of Figure 1. The electron-optical column 40 may comprise an electron emitter, which may comprise a cathode 203, an anode 220, and a gun aperture 222. The electron-optical column 40 may further include a Coulomb aperture array 224, a condenser lens 226, a beam-limiting aperture array 235, an objective lens assembly 232, and an electron detector 244. The electron-optical column 40 may further include a sample holder 236 supported by a motorized stage 234 to hold a sample 208 to be inspected. It is to be appreciated that other relevant components may be added or omitted, as needed.

In some embodiments, the electron emitter may include cathode 203, an extractor anode 220, wherein primary electrons can be emitted from the cathode and extracted or accelerated to form a primary electron beam 204 that forms a primary beam crossover 202 (virtual or real). The primary electron beam 204 can be visualized as being emitted from the primary beam crossover 202.

In some embodiments, the electron emitter, condenser lens 226, objective lens assembly 232, beam-limiting aperture array 235, and electron detector 244 may be aligned with a primary optical axis 201 of the apparatus 40. In some embodiments, the electron detector 244 may be placed off the primary optical axis 201, along a secondary optical axis (not shown).

Objective lens assembly 232, which may be an example of an objective lens arrangement, in some embodiments, may comprise a modified swing objective retarding immersion lens (SORIL), which includes a pole piece 232a, a control electrode 232b, a deflector 232c (or more than one deflector), and an exciting coil 232d. The objective lens assembly 232 may thus be an electromagnetic compound lens. In a general imaging process, primary electron beam 204 emanating from the tip of cathode 203 is accelerated by an accelerating voltage applied to anode 220. A portion of primary electron beam 204 passes through gun aperture 222, and an aperture of Coulomb aperture array 224, and is focused by condenser lens 226 so as to fully or partially pass through an aperture of beam-limiting aperture array 235. The electrons passing through the aperture of beam-limiting aperture array 235 may be focused to form a probe spot on the surface of sample 208 by the modified SORIL lens and deflected to scan the surface of sample 208 by deflector 232c. Secondary electrons emanated from the sample surface may be collected by electron detector 244 to form an image of the scanned area of interest.

In the objective lens assembly 232, the exciting coil 232d and the pole piece 232a may generate a magnetic field that is leaked out through the gap between two ends of the pole piece 232a and distributed in the area surrounding the optical axis 201. A part of the sample 208 being scanned by the primary electron beam 204 can be immersed in the magnetic field and can be electrically charged, which, in turn, creates an electric field in which the sample may be immersed. The immersion of the sample enables the beamlets to achieve a higher resolution. Electrostatic and magnetic immersion may reduce aberrations of objective lens assembly. As electrostatic and magnetic fields get stronger, the aberrations of objective lens 131 become smaller. Electrostatic field E, however, should be limited to within a safe range in order to avoid discharging or arcing on sample 208.

The electric field may reduce the energy of the impinging primary electron beam 204 near and on the surface of the sample 208. The control electrode 232b, being electrically isolated from the pole piece 232a, controls the electric field above and on the sample 208 to reduce aberrations of the objective lens assembly 232 and control focusing situation of signal electron beams for high detection efficiency. The control electrode 232b may comprise part of an electrostatic lens component of the objective lens assembly, for example with the pole piece 232a. Electrostatic lens component may be configured to influence and optimize the landing energy of the beamlets. The deflector 232c may deflect the primary electron beam 204 to facilitate beam scanning on the sample 208. For example, in a scanning process, the deflector 232c can be controlled to deflect the primary electron beam 204 onto different locations of the top surface of the sample 208 at different time points, to provide data for image reconstruction for different parts of the sample 208. The control electrode 232b may be positioned to be the element of the objective lens assembly positioned furthest down beam, for example most proximate to a sample. The deflector 232c is another electrostatic element positioned relatively proximate to the sample.

Backscattered electrons (BSEs) and secondary electrons (SEs) (which may be referred to collectively as signal electrons) can be emitted from the part of the sample 208 receiving the primary electron beam 204. The electron detector 244 may capture the BSEs and SEs and generate an image of the sample 208 based on the information collected from the captured signal electrons. If the electron detector 244 is positioned off the primary optical axis 201, a beam separator (not shown) can direct the BSEs and SEs to a sensor surface of the electron detector 244. The detected signal electron beams can form corresponding secondary electron beam spots on the sensor surface of the electron detector 244. The electron detector 244 can generate signals (e.g., voltages, currents) that represent the intensities of the received signal electron beam spots, and provide the signals to a processing system, such as the controller 50.

The intensity of secondary or backscattered electron beams, and the resultant beam spots, can vary according to the external or internal structure of the sample 208. Moreover, as discussed above, the primary electron beam 204 can be deflected onto different locations of the top surface of the sample 208 to generate secondary or backscattered signal electron beams (and the resultant beam spots) of different intensities. Therefore, by mapping the intensities of the signal electron beam spots with the locations of the primary electron beam 204 on the sample 208, the processing system can reconstruct an image of the sample 208 that reflects the internal or external structures of the sample 250. This reconstruction of an image of the sample 208 using signal electrons is described here with reference to the single beam arrangement of Figure 6, but it will be understood that a corresponding process can be used to reconstruct an image of the sample 208 in multi-beam arrangements such as those described above with reference to Figures 2-5.

In some embodiments, the controller 50 may comprise an image processing system. The image processing system may be configured to operate as described above with reference to Figure 2. The image processing system may include an image acquirer (not shown) and a storage (not shown). The image acquirer may comprise one or more processors. For example, the image acquirer may comprise a computer, server, mainframe host, terminals, personal computer, any kind of mobile computing devices, and the like, or a combination thereof. The image acquirer may be communicatively coupled to the electron detector 244 of the apparatus 40 through a medium such as an electrical conductor, optical fiber cable, portable storage media, IR, Bluetooth, internet, wireless network, wireless radio, among others, or a combination thereof. In some embodiments, the image acquirer may receive a signal from the electron detector 244 and may construct an image. The image acquirer may thus acquire images of regions of the sample 208. The image acquirer may also perform various post-processing functions, such as generating contours, superimposing indicators on an acquired image, and the like. The image acquirer may be configured to perform adjustments of brightness and contrast, etc. of acquired images. In some embodiments, the storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

In some embodiments, the controller 50 may include measurement circuitries (e.g., analog-to-digital converters) to obtain a distribution of the detected secondary electrons. The electron distribution data collected during a detection time window, in combination with corresponding scan path data of a primary beam 204 incident on the sample (e.g., a wafer) surface, can be used to reconstruct images of the wafer structures under inspection. The reconstructed images can be used to reveal various features of the internal or external structures of the sample 208, and thereby can be used to reveal any defects that may exist in the sample 208. This approach to revealing defects is described here with reference to the single beam arrangement of Figure 6, but it will be understood that a corresponding process can be used to reveal defects using multi-beam arrangements such as those described above with reference to Figures 2-5.

In some embodiments, the controller 50 may control the motorized stage 234 to move the sample 208 during inspection. In some embodiments, the controller 50 may enable the motorized stage 234 to move the sample 208 in a direction continuously at a constant speed. In other embodiments, the controller 50 may enable the motorized stage 234 to change the speed of the movement of the sample 208 over time depending on the steps of scanning process.

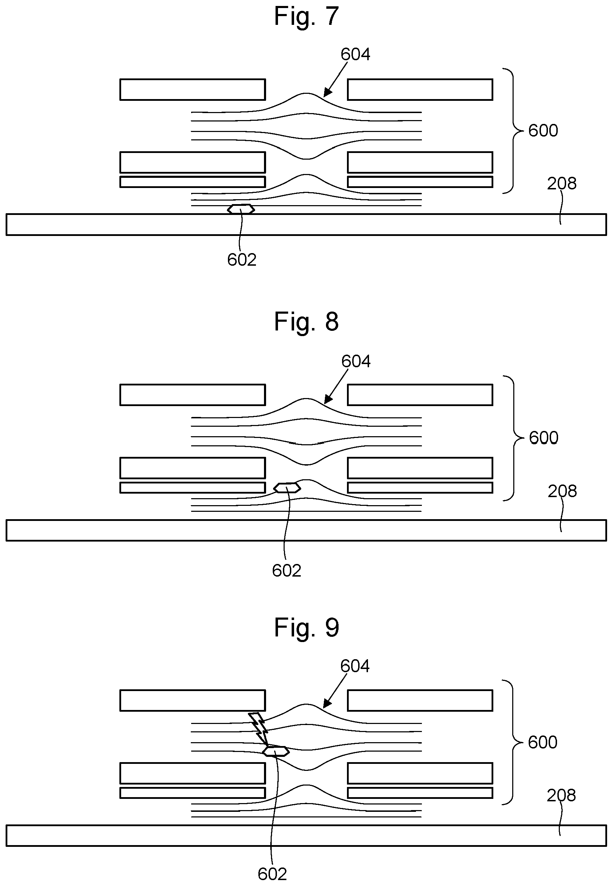

It is desirable to reduce the risk of electrostatic breakdown in high field regions of electron-optical columns. Figures 7-9 depict schematically how electrostatic breakdown may be triggered by a contaminant particle 602 moving into a high field region of an objective lens arrangement 600, which may be referred to as a part of the electron optical column which at least includes an objective lens or an objective lens array (for a multi-beam system). Thus, for example, in embodiments the objective lens arrangement 600 may be referred to as an objective lens. The electric field is schematically depicted by equipotential lines 604. Figure 7 depicts a particle 602 on a surface of a sample 208. Figure 8 depicts subsequent movement of the particle 602 towards a high field region within the objective lens arrangement 600. The movement may be driven by electrostatic forces. The presence of the particle 602 in a high field region increases the risk of electrostatic breakdown. For example, the particle 602, due to its shape and/or electrical permittivity, disturbs the field to locally increase the field above a threshold for dielectric breakdown. Figure 9 schematically shows electrostatic breakdown caused by the particle 602.

In operation, for example, the particle 602 is present on the surface of the sample 208 before the surface of the sample 208 is moved under the objective lens arrangement 600. (Note as other surfaces of the stage may be moved relative in proximity, for example under, the objective lens arrangement on which a particle may be present, reference to a sample surface may also refer to such a surface of the stage). The sample is supported by a support such as stage 234 so that the sample surface is moved under the objective lens arrangement 600. The electrostatic elements, e.g. electrodes, of the objective lens arrangement 600, generate an electric field as schematically represented by the equipotential lines 604 shown in Figures 7-9. As the particle moves with the sample surface it is drawn up towards the electrodes and even through an aperture in for example the down-beam-most electrode of the objective lens arrangement 600, as depicted in Figure 8. The net force on the particle may draw the particle further into the objective lens. On occasion, the particle may induce an electrostatic breakdown event in the objective lens arrangement 600 due to field concentration caused by the particle in a high field region of the objective lens arrangement 600.

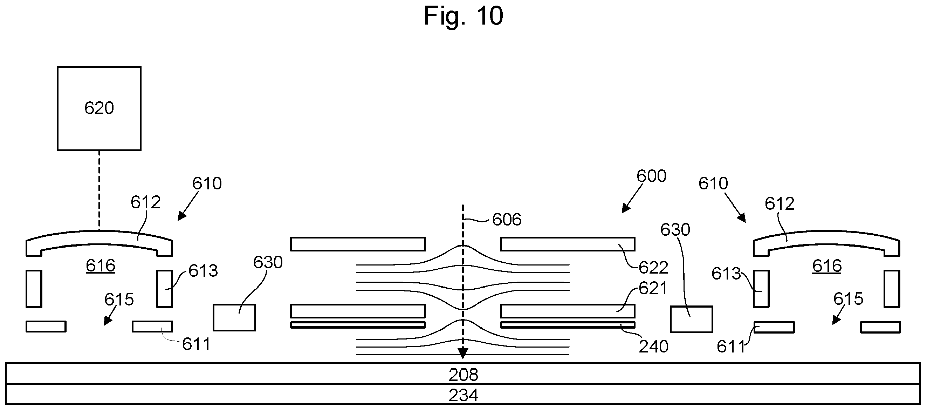

Figures 10-19 depict example embodiments of a particle trap for use in an electron-optical system (which may also be referred to as an electron-optical tool). The particle trap removes particles 602 from surfaces before the particles 602 can enter an objective lens arrangement 600. The particle trap thus reduces the risk of electrostatic breakdown in the objective lens arrangement 600. The electron-optical system may adopt any of the configurations described above with reference to Figures 1-6 or other configurations; the objective lens arrangement may take on the form of the objective lens arrangements such as an electrostatic objective lens array or a modified swing objective retarding immersion lens as described with respect to any of the systems described with reference to Figures 1 to 6, or another configuration.

The particle trap removes the particles 602 before the particles 602 can be drawn, for example up, into an objective lens arrangement 600. The objective lens arrangement 600 projects electrons towards the sample 208 along an electron-beam path 606. The objective lens arrangement 600 may comprise any suitable configuration for providing this functionality, for example the arrangements described herein with respect to Figures 1 to 6. The objective lens arrangement 600 may be configured to project a single beam of electrons in a single-beam column or a multi-beam of electrons in a multi-beam column. In the example shown, the objective lens arrangement 600 comprises a down-beam electrode 621 and an up-beam electrode 622. In other embodiments, the objective lens arrangement 600 may comprise one or more further electrodes. For example in an arrangement often used in a single beam column, the lens unit 600 may feature a magnetic lens element and one or more electrostatic lens elements, and one of the electrostatic lens elements may be positioned down beam, closer to the sample, than the magnetic lens element. In the case of a multi-beam column, as exemplified above with reference to Figures 2-5, each of the electrodes present in the respective design of objective lens arrangement, preferably proximate the sample surface, may define an aperture array. The objective lens arrangement 600 may take any of the forms described above for the objective lens 331 with reference to Figure 2, any of the forms described above for the objective lens array 241 with reference to Figures 3-5, or any of the forms described above for the objective lens assembly 232 with reference to Figure 6. The objective lens arrangement 600 may comprise one or more electrostatic lenses, one or more magnetic lenses, one or more control electrodes or another electrostatic element such as an electrostatic lensing electrode or deflector or manipulator, or any combination of these elements in which there would be a risk of electrical breakdown if a particle entered a region where the electric field strength is high in operation.

In the example shown in Figure 10, a detector 240 is provided that faces the sample 208. The detector 240 may be configured in any of the ways described above with reference to Figure 5 for example. Alternatively or additionally, an electron detector 244 of the type described with reference to Figure 6 may be provided.

The electron-optical system comprises a stage 234 for supporting a sample 208. The stage 234 is configured to move the sample 208 relative to an electron-beam path 606. The particle trap comprises an electrode assembly 610. The electrode assembly 610 is radially outside of the objective lens arrangement 600. The radial direction may be defined for example relative to a primary longitudinal axis of the electron-optical column, for example proximate the sample, and/or relative to an intended path, i.e. the electron beam path, of the electron immediately up beam of the sample. The electrode assembly 610 faces towards the sample 208. In some embodiments, the electrode assembly 610 comprises a sample-facing electrode 611. The sample-facing electrode 611 is the electrode of the electrode assembly 610 that is closest to the sample 208. The sample-facing electrode 611 will thus be the lowest electrode of the electrode assembly 610 when a last portion of the electron-beam path 606 is oriented vertically down beam, e.g. downwards.

The electrode assembly 610 is configured to draw a particle that may be present on the sample 208 and/or stage 234 away from the surface of the sample 208 and/or stage 234 as the sample 208 moves relative to the objective lens arrangement 600 (and, therefore, electron-beam path). In some embodiments, the electrode assembly 610 draws the particle away from the surface by pulling the particle towards the electrode assembly 610. The electrode assembly 610 may thus exert an attractive force on the particle. The electrode assembly 610 may be configured to draw the particle away from the surface when the movement of the stage 234 brings the particle to a position substantially beneath a portion of the electrode assembly 610. The electrode assembly may operate to draw up and remove the particle from the surface before the surface moves through a region in the vicinity of openings in the objective lens arrangement 600, for example through the beam path of the electron beam between the objective lens arrangement 600 and the surface of the sample 208.

In some embodiments, the electron-optical system comprises a control system 620. The control system 620 drives the electrode assembly 610 to generate an electric field to draw the particle from the surface. The force exerted by the electrode assembly may thus comprise an electrostatic force. The particle may thus be moved electrostatically, for example drawn from the surface electrostatically. The electrostatic force may arise due to the particle being charged and/or polarized. The electrode assembly 610 generates the electric field at least partially between the sample-facing electrode 611 (including any opening in the sample-facing electrode) and the sample 208. As described below, the electrode assembly 610 may additionally generate an electric field above the sample-facing electrode 611.

In some embodiments, and as mentioned, the particle trap is arranged so that the movement of the sample 208 will bring the particle 602 into a footprint of the particle trap before the particle is brought into a footprint of the objective lens arrangement 600. The footprint of the particle trap is outside of the footprint of the objective lens arrangement 600. The particle may thus be drawn from a portion of the surface of the sample 208 and/or stage 234 that is outside of the footprint of the objective lens arrangement 600, for example at a point in time. The particle may be drawn from the portion of the surface outside of the footprint of the objective lens arrangement 600 (e.g., from within the footprint of the particle trap) before the portion of the surface enters the footprint of the objective lens arrangement 600. The footprint of the particle trap is the portion of the surface of the sample 208 and/or stage 234 under the influence of forces applied by the particle trap. Typically, the footprint of the particle trap will be a region directly beneath the electrode assembly 610. Thus, the footprint of the particle trap may be a region of overlap between the electrode assembly 610 and the sample 208 when looking in a direction parallel to the down-beam direction of the electron-beam path 606 at the sample 208. The electrode assembly 610 may be orientated so that the sample facing electrode 611 is orientated to be substantially orthogonal to the down beam direction of the electron-beam path 606 at, or at least proximate to, the sample 208. The footprint of the objective lens arrangement 600 is the portion of the surface of the sample 208 directly beneath the objective lens arrangement 610 in a direction parallel to the down-beam direction of the electron-beam path 606 at the sample 208. The footprint of the objective lens arrangement 600 will thus comprise the region of the sample 208 that can be processed by the electrons projected by the objective lens arrangement 600, e.g. on which the electron beam may be incident and/or scanned across, at a given moment in time, or the region of the sample at a given moment in time which may be in movement through the beam path.. The footprint of the objective lens arrangement 600 may also comprise a surrounding region covered by sample facing elements of the objective lens arrangement 600, such as a down-beam electrode 621, a detector 240, or a control electrode 232b. In embodiments where the objective lens arrangement 600 is configured to project a multi-beam of electrons, the footprint of the objective lens arrangement 600 will comprise all of the regions of the sample 208 that can be processed by the sub-beams of the multi-beam for a fixed respective position of the sample 208 relative to the objective lens arrangement 600 or a position at a moment in time during a scan using motion of the stage 248. Arranging for the particle to be brought into the footprint of the particle trap before the footprint of the objective lens arrangement 600 ensures that, if the particle can be removed by the particle trap, the particle will be removed by the particle trap before the particle is brought to a position in which it might be pulled into the objective lens arrangement 600. In some embodiments, the particle trap is arranged so that a maximum force applied to a particle in the footprint of the particle trap is larger than a maximum force that would have been applied to the same particle in the footprint of the objective lens arrangement 600. Thus, if the particle trap is unable to pull a particle away from the surface, for example because the particle is too large or too strongly adhered to the surface, that particle will remain on the surface when the surface is moved to become the footprint of the objective lens; that is the particle cannot be pulled up into the objective lens arrangement 600. This may be achieved by arranging for the electric field between the electrode assembly 610 and a portion of the sample to be greater than the electric field generated between the objective lens arrangement 600 and the sample. The electric field generated by the electrode assembly 610 between the sample-facing electrode 611 of the electrode assembly 610 and the sample 208 (and/or between an opening 615 in the sample-facing electrode 611 and the sample 208) may thus have a larger maximum field strength than an electric field between the objective lens arrangement 600 and the sample 208 during the projection of electrons towards the sample 208 by the objective lens arrangement 600.

In some embodiments, the control system 620 drives the sample-facing electrode 611 such that a potential difference between the sample 208 and the sample-facing electrode 611 is substantially equal to or smaller than a potential difference between the sample 208 and a sample-facing portion of the objective lens arrangement 600. The sample-facing electrode 611 is thus at substantially the same electrical potential as a sample-facing portion of the objective lens arrangement 600 or at a lower electrical potential than the sample-facing portion of the objective lens arrangement 600. Arranging for the sample-facing electrode 611 to be at a similar potential to the sample-facing portion of the objective lens arrangement 600 reduces the risk of the particle trap having any non-significant influence on the electrons projected by the objective lens arrangement 600.

The maximum field strength from the particle trap can still be arranged to be similar to or higher than the maximum field strength under the objective lens arrangement 600 by positioning the sample-facing electrode 611 closer to the sample 208 than the sample-facing portion of the objective lens arrangement 600.

Alternatively or additionally, the control system may be configured to drive the sample-facing electrode 611 such that a potential difference between the sample 208 and the sample-facing electrode 611 is larger than a potential difference between the sample 208 and a sample-facing portion of the objective lens arrangement 600. In this case, the sample-facing electrode 611 may be provided at the same height or higher than the sample-facing portion of the objective lens arrangement 600 while still achieving a higher maximum field strength above the sample 208 surface.

Arranging for the sample-facing electrode 611 to be further from the sample 208 than the sample-facing portion of the objective lens arrangement 600 may be desirable to relax engineering tolerances for example in the clearance, flight height or distance between the sample facing electrode and the facing surface. The engineering tolerances may be determined to ensure that a risk of collision between the sample-facing electrode 611 and the sample 208 during movement of the sample 208 is acceptably low. The absolute separations between the objective lens arrangement 600 and the sample 208 and between the particle trap and the sample 208 may take various values. In some single beam arrangements, for example as described above with reference to Figure 6, the separation between the objective lens arrangement (e.g. objective lens assembly 232) and the sample 208 (e.g. between the control electrode 232b and the sample 208) may be in the region of 0.5-3.0mm, preferably 1-1.5mm. The separation between the particle trap and the sample 208 in such embodiments may be in the range of 0.5-2.0mm. For some multi beam arrangements, for example as described above with reference to Figures 2-5, the separation between the objective lens arrangement (e.g. objective lens 331 or objective lens array 241) and the sample 208 may be in the region of 25-150 microns. The separation between the particle trap and the sample 208 in such embodiments may be in the range of 100-500 microns. The measurements are exemplary and the specified types of dimension may be in a range which includes the maximum and minimum values mentioned.

In some embodiments, as shown in Figure 10, the electrode assembly 610 is spaced apart radially from the objective lens arrangement 600. This facilitates arranging for the sample-facing electrode 611 to be at a different potential to the sample-facing portion of the objective lens arrangement 600. In some embodiments, a protective plate 630 is provided between the electrode assembly 610 and the objective lens arrangement 600. The protective plate 630 may be held at substantially the same potential as the sample 208. The protective plate 630 may be part of a plate positioned above the stage and around the objective lens arrangement 600 or at least a part of the electron-optical column proximate the sample. The protective plate 630 may be configured to provide a clearly defined and constant electrical field between the protective plate 630 and the sample 208. The protective plate 630 may have a flat surface facing the sample 208. The protective plate 630 may electrically shield the sample 208 from irregularities such as protrusions or holes provided above the protective plate 630 (e.g. for mechanical reasons). The objective lens arrangement 600 may be at least partially shielded by the protective plate 630 from electric fields generated during the drawing of the particle away from the surface of the sample 208 and/or stage 234 by the particle trap. Alternatively or additionally, the particle trap may be positioned far enough away from where the electrons are projected onto the sample 208 by the objective lens arrangement 600 to ensure that the electrons are not influenced significantly, for example by fields generated by the particle trap. In an embodiment, a radially innermost portion of the sample-facing electrode 611 of the particle trap is positioned no closer than 3 times, preferably no closer than 5 times, a distance between the sample-facing portion of the objective lens arrangement 600 and the sample 208.

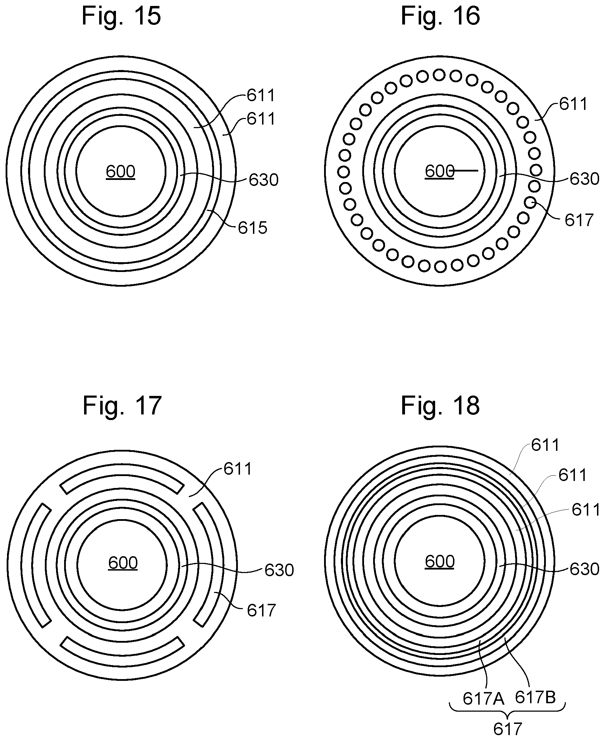

In some embodiments, to ensure that particles enter the footprint of the particle trap before the footprint of the objective lens arrangement 600, the particle trap may be provided in an annular form (when viewed parallel to an electron-beam path 606 onto the sample 208, for example in plan when viewed upbeam-wards). The particle trap may thus radially surround the objective lens arrangement 600. For example the particle trap may extend around a periphery of the sample facing element of the objective lens arrangement 600, preferably spaced apart from the objective lens arrangement 600. Example embodiments are depicted in Figures 15-18. In such embodiments, the sample-facing electrode 611 forms a closed loop radially surrounding the objective lens arrangement 600.

The sample-facing electrode 611 may form an annulus. The annulus may be spaced apart from the objective lens arrangement 600. Arranging for the sample-facing electrode 611 to radially surround the electrode lens unit 600 means that the particle 602 will always encounter the particle trap before reaching a position underneath the electrode lens unit 600, regardless of the relative direction of movement of the particle 602.

In some embodiments, the sample-facing electrode 611 defines an opening 615 (described in further detail below). The opening 615 may also form a closed loop radially surrounding the objective lens arrangement 600, as exemplified in Figure 15. The opening 615 may be defined in an annular shaped sample-facing electrode 611. The opening 615 may thus receive particles drawn away from the surface before the particles reach the footprint of the objective lens arrangement 600, regardless of the relative direction of movement of the particle 602. In other embodiments, as exemplified in Figures 16-18, the opening 615 is defined by a plurality of apertures 617. Providing a plurality of apertures 617, for example defined in the sample-facing electrode 611, provides increased flexibility for providing an electric field that is effective for pulling particles into the particle trap. Providing plural apertures 617 may additionally or alternatively facilitate structural rigidity and, for example, may aid manufacturability.

In some embodiments, as exemplified in Figures 16 and 17, at least a subset (or all) of the apertures 617 are at different azimuthal positions in the sample-facing electrode 611. In Figure 16, the apertures are a series of discrete apertures of for example similar shape, e.g. circular, of similar size, or of both similar size and shape. The apertures of an embodiment as depicted in Figure 17 are arcs of similar radius, of similar length or of both similar radius and length.

In some embodiments, as exemplified in Figure 18, at least a subset (or all) of the apertures 617 are at different radial positions in the sample-facing electrode 611. Figure 18 is an example of a class of embodiment in which plural annular apertures 617 are provided at different radii. In the example shown, two concentric annular apertures 617 are provided: a radially inner aperture 617A and a radially outer aperture 617B. Arrangements of this type may improve reliability by providing multiple chances for a particle to be picked up by the particle trap for any direction of movement of a particle underneath the particle trap. In any of the embodiments with multiple apertures, the apertures 617 may all have the same shape or different shapes. Any combination of features as depicted in and described with reference to Figures 15 to 18 may be provided. For example, an opening 615 may be provided that comprises apertures in concentric arrangements with a plurality of apertures provided along one or more closed loop paths, for example as arcs and/or discrete similar apertures.

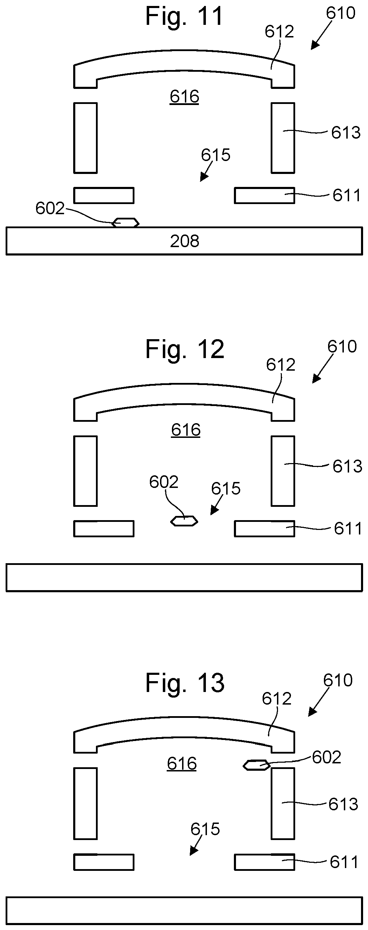

Referring again to Figure 10 for example, in some embodiments a particle drawn away from the surface of the sample 208 and/or stage 234 is trapped by the particle trap. The trapping is such that the particle 602 is held at a position away from the surface after the electric field used to perform the drawing of the particle 602 is removed (e.g., switched off). In some embodiments, the particle 602 is trapped within a cavity 616 within the electrode assembly 610. In embodiments of this type, the sample-facing electrode 611 may be configured to define an opening 615. The opening 615 allows particles drawn away from the surface to enter the cavity 616. The opening 615 may thus pass through the sample-facing electrode 611 into the cavity 616. The opening 615 may open out into, or be defined in, a surface of the sample-facing electrode 611 that faces towards the sample 208. In the orientation shown in Figure 10, the opening 615 extends vertically through the sample-facing electrode 611, for example so that a particle may pass through opening 615 into the cavity 616. The trapping process is depicted schematically in Figures 11-13. The operation of the trap in drawing the particle may be similar to the process of drawing a particle into the objective lens arrangement 600 as depicted and described with reference to Figures 7 to 9. Figure 11 depicts a particle 602 attached to the surface of the sample 208 and positioned under the sample-facing electrode 611 of the particle trap. Figure 12 depicts the particle 602 being drawn upwards away from the sample 208 and through the opening 615 in the sample-facing electrode 611. Figure 13 shows the particle 602 after the particle 602 has fully entered the cavity 616. The particle is depicted pushed to a lateral position within the cavity 616 to reduce the risk of the particle 602 falling back out of the cavity 616. (This functionality of pushing the particle to a lateral position within the cavity is described in further detail below).

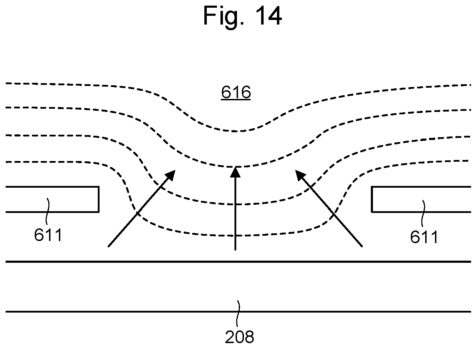

In some embodiments, the electric field generated by the electrode assembly 610 is configured to direct the particle through the opening 615. The electric field may thus be configured to make it more likely for a particle drawn away from the surface by the particle trap to pass through the opening 615 than to impact against the sample-facing electrode 611. For example, the electric field may be configured to be stronger between the sample 208 and the opening 615 than between sample 208 and the sample-facing electrode 611. Alternatively or additionally, the electric field may be configured so that at least a portion of field lines between the sample 208 and the sample-facing electrode 611 point towards the opening 615. In an arrangement the effective potential difference between the sample facing electrode and the sample surface may be substantially zero; the electric field through the opening should be sufficient to draw a particle from the sample above the sample facing electrode 611. An example configuration is depicted schematically in Figure 14, where equipotentials are depicted by broken lines and solid line arrows indicate example directions of forces that would be applied to charged particles in the field. Figure 14 is highly simplified and does not take account, for example, of adaptations that might be made to the electric field to draw particles away from a region above the opening 615 (as described in further detail below). Where such adaptations are made, the equipotentials may be more complex, particularly in regions away from the opening 615.

In some embodiments, the electrode assembly 610 comprises a distal electrode 612. The distal electrode 612 is positioned further from the sample than (e.g. above) the sample-facing electrode 611. The electric field generated by the electrode assembly 610 is generated by applying different electrical potentials to the sample-facing electrode 611 and the distal electrode 612. The electrode assembly may thereby generate the electric field partially in region on an opposite side of the sample-facing electrode from the sample 208 (e.g. above the sample-facing electrode 611 in a direction parallel to the upbeam direction). The electric field generated by the electrode assembly 610 for trapping particles may thus comprise a field component below the sample-facing electrode 611 and a field component above the sample-facing electrode 611. The electric field as a whole (above and below the sample-facing electrode 611) may be configured to draw particles through the opening 615 and, subsequently, to push the particles laterally. For example, when a particle passes through the opening 615 the particle may be directed away from positions, for example within a volume of the cavity, from which the particle is able to return through the opening, for example towards the surface. These positions may include positions above or nearly above the opening 615. The particle is thus directed towards locations of the cavity surface, as depicted schematically in Figure 13, from which the particle has a low risk of returning through the opening 615. This functionality may be achieved by arranging for at least a portion of an interior surface of the distal electrode 612 (i.e., a surface facing into the cavity 616) to be non-planar. The non-planar portion may comprise one or more smoothly curved regions and/or one or more regions made up of non-parallel planar sub-elements. The regions made up of non-parallel planar sub-elements may be referred to as angular regions.

Alternatively or additionally, the functionality of directing particles towards regions of low risk of return through the opening 615 may be at least partly achieved by providing one or more further electrodes 613 in the electrode assembly 610. Each further electrode 613 is electrically isolated from the sample-facing electrode 611 and the distal electrode 612. The sample-facing electrode 611, distal electrode 612 and further electrodes 613 may thus be held at different potentials relative to each other. Each further electrode 613 is positioned radially inward of the opening 615 or radially outward of the opening 615. Each further electrode 613 may be configured to adjust the electric field in the cavity 616 to attract a charged particle in the trap towards the further electrode 613. In the examples depicted in Figures 10-13 and 19, two further electrodes 613 are provided. One of the further electrodes 613 is radially inward of the opening 615. The other further electrode 613 is radially outward of the opening 615. In the case where multiple further electrodes 613 are provided and maintained at the same potential, the further electrodes 613 may or may not be connected to each other electrically. In the case where the further electrodes 613 are connected to each other electrically, the electrically connected further electrodes 613 may optionally be considered to be a single further electrode 613.

In an embodiment, the distal electrode 612 has a larger area than the opening 615 defined in the sample-facing electrode 611. The cavity 616 may thus be wider in a radial direction than the opening 615. Making the distal electrode 612 and/or cavity 616 wider in the radial direction facilitates directing captured particles away from regions of the cavity 616 from which the particles could fall back through the opening 615 and onto the sample 208. A surface of the sample-facing electrode 611 facing into the cavity 616 may act as a ledge to capture particles 602 falling downwards, for example after the particle trap is switched off or after the particles have lost their charge.

The distal electrode 612 may be mechanically connected to the sample-facing electrode 611 and/or to any further electrodes 613 by one or more electrically insulating spacers or other structural elements, which are not shown in the figures for clarity. Any such electrically insulating elements may comprise any suitable electrically insulating material, such as ceramic or glass. In some embodiments, the cavity 616 is closed above the sample-facing electrode 611, for example by a combination of the distal electrode 612, any further electrodes 613, and electrically insulating spacers or other structural elements. The cavity 616 may be sealed except for one or more openings 615 through the sample-facing electrode 611.

In some embodiments, the maximum field strength of the electric field generated in a region on the opposite side of the sample-facing electrode 611 from the sample 208 (e.g. above the sample-facing electrode 611 in the cavity 616) is smaller than a maximum field strength of an electric field generated in the objective lens arrangement 600. In an embodiment, this condition is satisfied during the projection of electrons towards the sample 208. Thus, particles entering the particle trap are less likely to cause electrical breakdown in the particle trap than if they entered the objective lens arrangement 600. In some embodiments, a maximum field strength of the electric field generated above the sample-facing electrode 611 is arranged to be smaller than 10 kV/mm, preferably smaller than 2.5 kV/mm. Keeping the electric fields at such low levels achieves an acceptably low risk of particle-induced electrical breakdown.

Any of the embodiments comprising or using a particle trap described above may be implemented in the context of a multi-column electron-optical system. In an embodiment of this type, the electron-optical system may therefore comprise a plurality of electron-optical columns 500, for example as described above with reference to Figure 4. Each of the electron-optical columns 500 comprises an objective lens arrangement 600. In some embodiments, the electrode-assembly 610 of the particle trap is provided radially outside of all or a subset of the objective lens arrangements 600. Alternatively, a plurality of the particle traps may be provided, with the electrode assembly 610 of each particle trap being radially outside a different respective one or subset of the objective lens arrangements 600.

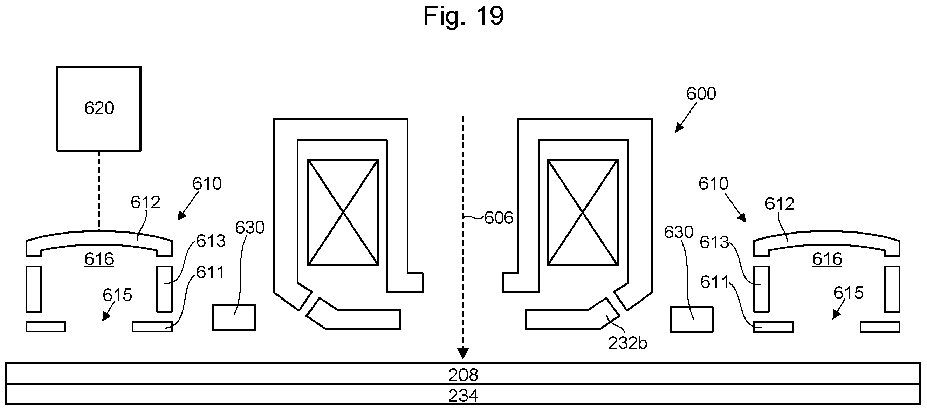

The above-described embodiments comprising or using a particle trap have been exemplified mainly with reference to an electrostatic objective lens arrangement 600. The objective lens arrangement 600 may also comprise a magnetic lens, as exemplified in Figure 19. The objective lens arrangement 600 of Figure 19 may take any of the forms described above for the objective lens assembly 232 with reference to Figure 6. Implementations using magnetic lenses, as shown in and described with reference to Figure 6, comprise electrostatic elements, such as the control electrode 232b, that may be more proximate the facing surface, e.g. of the sample 208 than the magnetic lens elements of the objective lens assembly or other electrostatic elements which may be more remote from the sample.. Such electrostatic elements more proximate the facing surface may be more susceptible to discharge for example on interaction with a particle present on a facing surface In addition to the functions described above for control electrode 232b, an electrode provided with a magnetic lens may be used to influence the landing energy of the electron beam or multi-beam. The electrode may be used, for example, to ensure that the primary electrons impinge on the sample 208 at a relatively low kinetic energy and pass through the electron-optical column at a relatively high kinetic energy. Alternatively or additionally, the electrode may form part of an electrostatic lens used in combination with the magnetic lens. The electrode may be used to adjust the shape of the field of the electrostatic lens. The electrode may also be used for rotation control. The risk of particle-induced electrical breakdown may also therefore be present where magnetic lenses are used. It is therefore also desirable to incorporate the particle trap into electron-optical systems that use magnetic lenses.

References to upper and lower, up and down, above and below, etc. in relation to embodiments containing or using a particle trap should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Although references to such electron optical elements such as objective lens arrangement 600 in Figures 10 as objective lens array 240 refer to them as electrostatic, in an arrangement such electron-optical elements may have a magnetic elements. Such a compound array lens may feature a macro magnetic lens encompassing the multi-beam path with an upper and lower pole plate within the magnetic lens and arrange along the multi-beam path. In the pole plates may be an array of apertures for the beam paths of the multi-beam. Electrodes may be present above, below or between the pole plates to control and optimize the electro-magnetic field of the compound lens array.

An assessment tool according to an embodiment (e.g. using an electron-optical system as described above) may be a tool which makes a qualitative assessment of a sample 208 (e.g. pass/fail), one which makes a measurement such as a quantitative measurement (e.g. the size of a feature) of a sample 208 or one which generates an image or map of a sample 208. Examples of assessment tools are inspection tools (e.g. for identifying defects), review tools (e.g. for classifying defects) and metrology tools.

Any reference to a tool herein is intended to encompass a device, apparatus or system, the tool comprising various components which may or may not be collocated, and which may even be located in separate rooms, especially for example for data processing elements.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies) to control the component to manipulate the charged particle beam in this manner. For example, a voltage supply may be electrically connected to one or more components to apply potentials to the components, such as in a non-limited list the particle trap 610, the sample facing electrode 611 and components of the objective lens arrangement 600, under the control of the controller or control system or control unit. An actuatable component, such as a stage, may be controllable to actuate and thus move relative to another components such as the beam path using one or more controllers, control systems, or control units to control the actuation of the component..

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses. There is provided the following clauses:
Clause 1: An electron-optical system, comprising: a stage configured to support a sample; an objective lens arrangement of an electron-optical column configured to project electrons towards the sample along an electron-beam path, the stage configured to move the sample relative to the electron-beam path; and a particle trap comprising: an electrode assembly radially outside of the objective lens arrangement and configured to face towards the sample, the electrode assembly being configured to draw a particle away from a surface of the sample and/or stage as the sample moves relative to the electron-beam path.
Clause 2. The system of claim 1, further comprising a control system configured to drive the electrode assembly to generate an electric field to draw the particle from the surface.
Clause 3. The system of claim 2, wherein the electrode assembly is configured to generate the electric field at least partially between a sample-facing electrode of the electrode assembly and the sample.
Clause 4. The system of claim 3, wherein the sample-facing electrode defines an opening through the sample-facing electrode.
Clause 5. The system of claim 3 or 4, wherein the generated electric field between the sample-facing electrode of the electrode assembly, or where present the opening, and the sample has a larger maximum field strength than an electric field between the objective lens arrangement and the sample during the projection of electrons towards the sample by the objective lens arrangement.
Clause 6. The system of claim 4 or 5, wherein the electrode assembly comprises a distal electrode configured to be positioned further from the sample than the sample-facing electrode, the distal electrode preferably having a larger area than the opening defined in the sample-facing electrode.
Clause 7. The system of claim 6, wherein the opening passes through the sample-facing electrode into a cavity within the electrode assembly.
Clause 8. The system of claim 7, wherein the cavity is closed above the sample-facing electrode.
Clause 9. The system of claim 7 or 8, wherein the cavity is wider in the radial direction than the opening.
Clause 10. The system of any of claims 4-9, wherein the electrode assembly is configured to generate the electric field partially in a region on an opposite side of the sample-facing electrode from the sample.
Clause 11. The system of claim 10, wherein a maximum field strength of the electric field generated in the region on the opposite side of the sample-facing electrode from the sample is smaller than a maximum field strength of an electric field generated in the objective lens arrangement during the projection of electrons towards the sample.
Clause 12. The system of claim 10 or 11, wherein a maximum field strength of the electric field generated in the region on the opposite side of the sample-facing electrode from the sample is smaller than 10 kV/mm.
Clause 13. The system of any of claims 10-12, wherein the electric field is configured so that when a particle passes through the opening the particle is directed away from positions from which the particle is able to return through the opening, preferably away from positions above the opening.
Clause 14. The system of claim 13, wherein the electrode assembly comprises a distal electrode configured to be positioned further from the sample than the sample-facing electrode, and the distal electrode has a non-planar, preferably curved or angular, surface.
Clause 15. The system of claim 13 or 14, wherein the electrode assembly comprises one or more further electrodes, each further electrode being electrically isolated from the sample-facing electrode and the distal electrode and positioned radially inward or outward of the opening.
Clause 16. The system of any of claims 4-15, wherein the sample-facing electrode forms a closed loop radially surrounding the objective lens arrangement, preferably in the form of an annulus.
Clause 17. The system of claim 16, wherein the opening is a closed loop radially surrounding the objective lens arrangement.
Clause 18. The system of any of claims 4-17, wherein the opening is defined by a plurality of apertures, at least a subset of the apertures being at different azimuthal positions and/or radial positions in the sample-facing electrode, preferably at least a subset of the apertures forming closed loops surrounding the objective lens arrangement at different respective radial positions.
Clause 19. The system of any of claims 3-18, wherein the control system is configured to drive the sample-facing electrode such that a potential difference between the sample and the sample-facing electrode is larger than a potential difference between the sample and a sample-facing portion of the objective lens arrangement.
Clause 20. The system of any of claims 3-19, wherein the sample-facing electrode is configured to be at the same distance or further from the sample than the sample-facing portion of the objective lens arrangement.
Clause 21. The system of any of claims 3-18, wherein the control system is configured to drive the sample-facing electrode such that a potential difference between the sample and the sample-facing electrode is substantially equal to or smaller than a potential difference between the sample and a sample-facing portion of the objective lens arrangement.
Clause 22. The system of any of claims 3-19 or 21, wherein the sample-facing electrode is configured to be closer to the sample than a sample-facing portion of the objective lens arrangement.
Clause 23. The system of any preceding claim, wherein the electrode assembly is spaced apart radially from the objective lens arrangement, preferably with a protective plate radially between the electrode assembly and the objective lens arrangement, preferably with the protective plate held at substantially the same potential as the sample.
Clause 24. The system of any preceding claim, wherein: the system comprises a plurality of the electron-optical columns and objective lens arrangements; and the electrode assembly of the particle trap is radially outside all or a subset of the objective lens arrangements; or a plurality of the particle traps are provided, the electrode assembly of each particle trap being radially outside a different respective one or subset of the objective lens arrangements.
Clause 25. The system of any preceding claim, wherein: the electrode assembly is configured to draw the particle away from a portion of the surface when the electrode assembly faces the portion during movement of the surface relative to the objective lens arrangement.
Clause 26. A method of operating an electron-optical system, comprising: projecting electrons towards the sample along an electron-beam path using an objective lens arrangement; moving the sample on a stage relative to the electron-beam path; and drawing a particle away from a surface of the sample and/or stage as the sample moves.
Clause 27. The method of claim 26, wherein the particle is drawn from a portion of the surface of the sample and/or stage that is outside of a footprint of the objective lens arrangement.
Clause 28. The method of claim 27, wherein the particle is drawn from the portion of the surface outside of the footprint before the portion of the surface enters the footprint.
Clause 29. The method of any of claims 26-28, wherein the particle is drawn electrostatically.
Clause 30. The method of claim 29, wherein a maximum field strength of an electric field used to perform the drawing of the particle is smaller than a maximum field strength of an electric field generated in the objective lens arrangement during the projection of electrons towards the sample.
Clause 31. The method of any of claims 26-30, further comprising trapping the particle drawn from the surface.
Clause 32. The method of claim 31, wherein the trapping is such that the particle remains trapped away from the surface after an electric field used to perform the drawing of the particle is removed.
Clause 33. The method of claim 32, wherein the electric field is used to direct the particle through an opening in an electrode assembly used to generate the electric field.
Clause 34. The method of claim 33, wherein, after the particle has passed through the opening, the electric field directs the particle away from positions from which the particle is able to return through the opening, preferably away from positions above the opening.35. The method of any of claims 26-34, further comprising shielding the objective lens arrangement from electric fields generated during the drawing of the particle from the surface.
Clause 36. A particle trap for an electron-optical system, the electron-optical system comprising an objective lens arrangement of an electron-optical column configured to project electrons towards a sample along an electron-beam path, the particle trap comprising: an electrode assembly configured to be mounted radially outside of the objective lens arrangement and to face towards the sample, the electrode assembly being configured to draw a particle away from a surface of the sample, and/or a stage on which the sample is supported, as the sample moves relative to the electron-beam path.

The descriptions above are intended to be illustrative, not limiting. Thus, it will be apparent to one skilled in the art that modifications may be made as described without departing from the scope of the claims set out below.

## Claims

1. An electron-optical system, comprising:
a stage configured to support a sample;
an objective lens arrangement of an electron-optical column configured to project electrons towards the sample along an electron-beam path, the stage configured to move the sample relative to the electron-beam path; and
a particle trap comprising: an electrode assembly radially outside of the objective lens arrangement and configured to face towards the sample, the electrode assembly being configured to draw a particle away from a surface of the sample and/or stage as the sample moves relative to the electron-beam path.

2. The system of claim 1, further comprising a control system configured to drive the electrode assembly to generate an electric field to draw the particle from the surface.

3. The system of claim 2, wherein the electrode assembly is configured to generate the electric field at least partially between a sample-facing electrode of the electrode assembly and the sample.

4. The system of claim 3, wherein the sample-facing electrode defines an opening through the sample-facing electrode.

5. The system of claim 3 or 4, wherein the generated electric field between the sample-facing electrode of the electrode assembly, or where present the opening, and the sample has a larger maximum field strength than an electric field between the objective lens arrangement and the sample during the projection of electrons towards the sample by the objective lens arrangement.

6. The system of claim 4 or 5, wherein the electrode assembly comprises a distal electrode configured to be positioned further from the sample than the sample-facing electrode, the distal electrode preferably having a larger area than the opening defined in the sample-facing electrode.

7. The system of claim 6, wherein the opening passes through the sample-facing electrode into a cavity within the electrode assembly.

8. The system of claim 7, wherein the cavity is closed above the sample-facing electrode.

9. The system of claim 7 or 8, wherein the cavity is wider in the radial direction than the opening.

10. The system of any of claims 4-9, wherein the electrode assembly is configured to generate the electric field partially in a region on an opposite side of the sample-facing electrode from the sample.

11. The system of claim 10, wherein the electric field is configured so that when a particle passes through the opening the particle is directed away from positions from which the particle is able to return through the opening, preferably away from positions above the opening.

12. The system of any of claims 4-11, wherein the sample-facing electrode forms a closed loop radially surrounding the objective lens arrangement, preferably in the form of an annulus.

13. The system of any of claims 4-12, wherein the opening is defined by a plurality of apertures, at least a subset of the apertures being at different azimuthal positions and/or radial positions in the sample-facing electrode, preferably at least a subset of the apertures forming closed loops surrounding the objective lens arrangement at different respective radial positions.

14. The system of any of claims 3-13, wherein the control system is configured to drive the sample-facing electrode such that a potential difference between the sample and the sample-facing electrode is larger than a potential difference between the sample and a sample-facing portion of the objective lens arrangement.

15. The system of any of claims 3-14, wherein the sample-facing electrode is configured to be at the same distance or further from the sample than the sample-facing portion of the objective lens arrangement, or wherein the sample-facing electrode is configured to be closer to the sample than a sample-facing portion of the objective lens arrangement.
